# EUROPEAN PATENT APPLICATION

(11) **EP 4 708 049 A1**
(43) Date of publication of application: **11.03.2026**
(21) Application number: 25198498.5
(22) Date of filing: 27.08.2025
(51) Int. Cl.: G06F 9/50, G06Q 10/0631

(54) **DEMAND FULFILLMENT MODELING FOR SUPPLY-CONSTRAINED RESOURCES**

(30) Priority: 28.08.2024 US 202418817908
(71) Applicant: Google LLC, Mountain View, CA 94043 (US)
(72) Inventor: SAMPATHKUMARAN, Anuj, Mountain View, 94043 (US); RASKASKY, Miriam, Mountain View, 94043 (US)
(74) Representative: Betten & Resch

(57) **Abstract**

The present disclosure provides methods and systems for managing user queries concerning fulfillment of requests to use a supply constrained resource. A method may involve receiving a user query specifying a requested supply constrained resource, the user query including one or more parameters, providing the user query to a solver engine, accessing availability information indicating an availability of the supply constrained resource, determining a partitioning of the supply constrained resource based on the availability information, providing the determined partitioning of the supply constrained resource to the solver engine, determining, by the solver engine, a feasibility of a user request to use the supply constrained resource having the one or more parameters of the user query, and outputting, from the solver engine, the determined feasibility of the user request.

## Description

### BACKGROUND

Modern computing systems rely on components for which supply of the components is constrained, referred to herein as "supply constrained resources." For example, latest-generation accelerator chips are typically in short supply relative to their high demand, making them a supply-constrained resource. It is increasingly important to maximize utilization of available supply constrained resources, such as by pooling the available resources for shared use by multiple users, and queuing and scheduling user requests for use of the pool of resources.

Because of the constrained supply, availability of the shared resources can be unpredictable. However, many users wish to understand, before purchasing capacity of the pooled resources, the feasibility of obtaining the desired capacity under different scenarios, such as over time, location, as well as other factors that may vary depending on the type of resource being demanded.

### BRIEF SUMMARY

The present disclosure provides a solution for modeling demand feasibility for supply constrained resource. The model can be used to provide answers to various questions relating to supply capacity.

One aspect of the disclosure provides for a method including: receiving a user query specifying a requested supply constrained resource, wherein the user query includes one or more parameters; providing the user query to a solver engine; providing to a capacity data calculator service, availability information indicating an availability of the supply constrained resource; determining, by the capacity data calculator service, a partitioning of the supply constrained resource based on the availability information; providing the determined partitioning of the supply constrained resource to the solver engine; determining, by the solver engine, a feasibility of a user request to use the supply constrained resource having the one or more parameters of the user query, wherein determining the feasibility is based on a model of supply and demand of the supply constrained resource, wherein supply of the supply constrained resource is modeled according to the determined partitioning of the supply constrained resource; and outputting, from the solver engine, the determined feasibility of the user request.

In some examples, the one or more parameters may include at least: an amount of the supply constrained resource to be used for a given task; and a time at which, or a time period over which, the supply constrained resource is to be used for the given task.

In some examples, the one or more parameters may include a priority level of the given task indicating to prioritize use of the supply constrained resource for the given task over other tasks having a lower priority level.

In some examples, feasibility of the user request may indicate whether or not the user request having the one or more parameters can be fulfilled using an available capacity of the supply constrained resource.

In some examples, feasibility of the user request may indicate, for a user request that cannot be fulfilled using the available capacity of the supply constrained resource, a modified set of parameters for which the user request having the modified set of parameters can be fulfilled using the available capacity of the supply constrained resource.

In some examples, feasibility of the user request may indicate, for a user request that cannot be fulfilled using the available capacity of the supply constrained resource, one or more existing tasks for which preemption of the one or more tasks would result in the user request being capable of being fulfilled using the available capacity of the supply constrained resource.

In some examples, feasibility of the user request may indicate a percentage likelihood of whether or not the user request having the one or more parameters can be fulfilled using an available capacity of the supply constrained resource.

In some examples, in the model of supply and demand of the supply constrained resource, demand of the supply constrained resource may be modeled according to historical data of current and prior user requests for use of the supply constrained resource.

In some examples, the historical data may include performance data indicating performance of resources handling the current and prior user requests.

In some examples, the model may be a machine learning model that is trained on the performance data and the determined partitioning of the supply constrained resource.

In some examples, the availability information may indicate one or more topologies of the supply constrained resource, and the determined partitioning may be based on the one or more topologies.

In some examples, the determined partitioning of the supply constrained resource may be a time-series of slice budgets of the supply constrained resource over a span of time.

In some examples, the supply constrained resource may be one of a graphics processing unit (GPU) or a tensor processing unit (TPU).

In some examples, providing the determined partitioning of the supply constrained resource to the solver engine may be performed at predetermined intervals.

In some examples, the method may further include, in response to receiving the user query, pushing a query notification to the capacity data calculator service. The query notification may include an instruction for the capacity data calculator service to update the partitioning of the supply constrained resource and provide the updated partitioning to the solver.

In some examples, the method may further include storing the user query including the one or more parameters in a user query storage containing a plurality of previously received user queries; and providing the plurality of previously received user queries to the solver engine, wherein in the model of supply and demand of the supply constrained resource, demand of the supply constrained resource is modeled at least in part according to the plurality of previously received user queries.

In some examples, the method may further include: receiving a user request committing to use of the supplied constrained resource, the user request corresponding to the user query; providing the user request to a scheduler engine to allocate the supply constrained resource for fulfillment of the user request; and in response to receipt of the user request, deleting the corresponding user query from the user query storage.

In some examples, the method may further include: receiving a user request committing to use of the supplied constrained resource, the user request corresponding to the user query; providing the user request to a scheduler engine; and allocating, by the scheduler engine, the supply constrained resource for fulfillment of the user request.

In some examples, allocating the supply constrained resource may be based on the model of supply and demand of the supply constrained resource

Another aspect of the disclosure is directed to a system including: one or more processors; and memory having stored therein instructions configured to cause the one or more processors to: receive a user query specifying a requested supply constrained resource, wherein the user query includes one or more parameters; provide the user query to a solver engine; access availability information indicating an availability of the supply constrained resource; determine a partitioning of the supply constrained resource based on the availability information; provide the determined partitioning of the supply constrained resource to the solver engine; receive, from the solver engine, an indication of feasibility of a user request to use the supply constrained resource having the one or more parameters of the user query, wherein the indication of feasibility is based on a model of supply and demand of the supply constrained resource, wherein supply of the supply constrained resource is modeled according to the determined partitioning of the supply constrained resource; and output the determined feasibility of the user request to a source of the user query.

According to another aspect of the disclosure, there is provided a computer program comprising instructions which, when the program is executed by one or more processors, cause the one or more processors to carry out at least one of the methods as described in the present disclosure.

### BRIEF DESCRIPTION OF THE DRAWINGS

Fig. 1 is a block diagram of a system in accordance with an aspect of the disclosure.
Figs. 2-5 is a data flow diagram of example systems in accordance with aspects of the disclosure.
Figs. 6 and 7 are flow diagrams of example routines in accordance with aspects of the disclosure.

### DETAILED DESCRIPTION

### Overview

The present disclosure provides a solution for modeling demand feasibility for a supply constrained resource. The model can be used to provide answers to various questions relating to supply capacity, including: given the available capacity, can a user request for a specified resource be fulfilled at or within a specified time period; if the user request cannot be fulfilled, what parameters of user request could be changed in order to make the request capable of being fulfilled; or can the user request be fulfilled if one or more other specific tasks are disrupted or otherwise preempted.

In one example data flow for implementing the solution, a user query is received through a user interface. The user query may request information about feasibility of a user request to use a supply-constrained resource, and may include one or more parameters such as an amount of the supply constrained resource and a time or time period of the requested use. The user interface may provide the user query to a solver, which may be programmed to provide a response regarding feasibility of the user query. Feasibility may refer to a "yes" or "no" answer to whether the resources specified in the user query are available within the time period specified in the user query. Additionally or alternatively, for user queries that return an answer of "no," feasibility may also refer to additional information that is considered responsive to the user query. One example of such additional information is an indication of parameter changes to the user query that would change the response to the user query from "no" to "yes." Another example of additional information is an indication of one or more other tasks that, if preempted by the user request, would change the response to the user query from "no" to "yes."

In order to process and determine feasibility of the user queries, the solver may run a model of the available capacity of the supply constrained resource. Behavior of the model may be defined by inputs received from historical data of current and past user requests, as well as inputs from a capacity data calculator subsystem. The capacity data calculator subsystem may be programmed to determine an appropriate partitioning of the supply constrained resource based on current and future resource availability information.

For example, in the case of a service that manages available capacity of tensor processing units (TPUs), the capacity data calculator subsystem may compute slice budgets for the TPUs based on capacity data indicating current and future available TPU resources. Since available TPU resources may change over time, the compute slice budget information provided to the solver may also be provided as a function of time, such as a time series of slice budgets.

The solver may compute appropriate allocations of the supply constrained resource using the model and based on the inputs and the user query. Once one or more appropriate allocations are determined, these allocations may be used to answer the question of feasibility contained in the user query, which in turn may be contained in the output of the solver. The solver output may then be provided as a response to the user query in order to inform users of whether to proceed with a request to use the supply constrained resource in accordance with the parameters of the user query, in accordance with a modified set of parameters, or not at all.

The methods and systems of the present disclosure may provide users with reliable and up-to-date answers regarding feasibility of a request to use a supply constrained resource before the request is officially issued. This can help to improve user confidence in subsequently issued user requests, thus making users more willing to commit to and invest in the supply constrained resource without excessive or undue worrying about unexpected fluctuations in resource availability, thus improving user satisfaction. The systems and methods can also help to optimize resource utilization.

### Example Systems

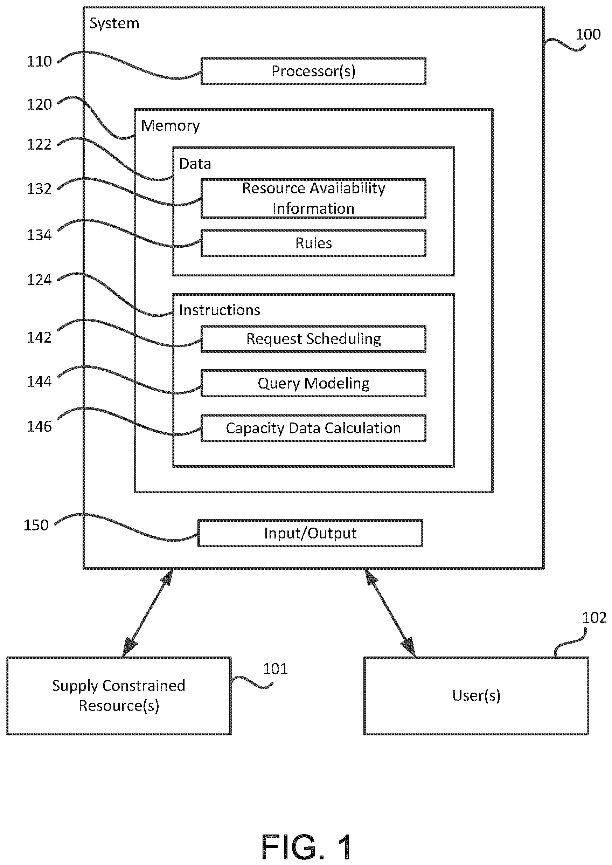

Fig. 1 is a block diagram of an example system 100 in accordance with an aspect of the disclosure. In the example of Fig. 1, the system 100 may include one or more of a supply constrained resource 101 which can be allocated among users 102 of the system. The supply constrained resource 101 may be a component for which supply is not easily scalable to meet demand, thereby typically resulting in high demand for limited supply. Additionally, the supply constrained resource may be a component that is topologically adjustable, meaning that the available supply can be dynamically partitioned and repartitioned into discrete denominations, and then allocated according to these discrete denominations.

One example of a supply constrained resource is a tensor processing unit (TPU). The TPU is a hardware accelerator often used for accelerating machine learning tasks. As implementation of machine learning tasks expands and demand for accelerators for the machine learning tasks grows, the demand for TPUs can increase faster than or close to as fast as the available supply of TPUs, thus rendering the TPUs a supply constrained resource. Additionally, TPUs may be dynamically partitioned, whereby the available accelerators may be grouped into discrete slices and the slices may be made available to users based on user requests. Another example of a supply constrained resource may be a graphics processing unit (GPU), which too can be dynamically partitioned according to discrete denominations and then allocated according to those denominations. However, it should be recognized that the principles of the present disclosure are not limited to allocation of TPUs and GPUs, but can be applied to any other component having a supply-demand mismatch and that is dynamically partitionable as with TPUs and GPUs.

The system 100 may further include additional components used for management of the allocation of the supply constrained resource 101, such as one or more processors 110, memory 120 storing data 122 and instructions 124 that may be executed or otherwise used by the processors 110, and an input/output system 150 which may be interconnected via a network (not shown).

The one or more processors 110 may be any conventional processor, such as commercially available CPUs. Alternatively, the one or more processors may be a dedicated device such as an ASIC or other hardware-based processor. Although Fig. 1 functionally illustrates the processor, memory, and other elements of computing devices 100 as being within the same block, it will be understood by those of ordinary skill in the art that the processor, computing device, or memory may actually include multiple processors, computing devices, or memories that may or may not be located or stored within the same physical housing. In one example, one or more computing devices 100 may include one or more server computing devices having a plurality of computing devices, e.g., a load balanced server farm, that exchange information with different nodes of a network for the purpose of receiving, processing and transmitting the data to and from other computing devices as part of customer's business operation.

The memory 120 may be of any type capable of storing information accessible by the processor, including a computing device-readable medium, or other medium that stores data that may be read with the aid of an electronic device, such as a hard-drive, memory card, ROM, RAM, DVD or other optical disks, as well as other write-capable and read-only memories. Systems and methods may include different combinations of the foregoing, whereby different portions of the instructions and data are stored on different types of media.

The data 122 may be retrieved, stored or modified by processor 110 in accordance with the instructions 124. As an example, data 122 associated with memory 120 may include resource availability information 132 about existing and/or potential requests for the supply constrained resource at current or future time periods. For further example, the data 122 may include one or more rules 134 or settings for determining partitioning of the supply constrained resource.

The instructions 124 may be any set of instructions to be executed directly, such as machine code, or indirectly, such as scripts, by the processors. For example, the instructions may be stored as computing device code on the computing device-readable medium. In that regard, the terms "instructions" and "programs" may be used interchangeably herein. The instructions may be stored in object code format for direct processing by the processor, or in any other computing device language including scripts or collections of independent source code modules that are interpreted on demand or compiled in advance. As an example, instructions 124 associated with the memory 120 may comprise user request scheduling instructions 142, user query modeling instructions 144, capacity data calculation instructions 146, and so on.

User request scheduling instructions 142 may involve one or more processes for maintaining up-to-date records of user requests to use the supply constrained resource. In the context of the present disclosure, user requests may include both actual user commitments to the supply constrained resource, as well as user inquiries into feasibility of potential user requests. In other words, a user may be interested in acquiring access to the supply constrained resource, but may not have a good sense of whether the resource will be available at a desired time for the use, or in a desired quantity for the use. Such a user may initiate a query to determine the feasibility of a potential request to use the supply constrained resource, which in turn may instruct the user whether or not to make a commitment to the supply constrained resource. Although such inquiries are not themselves commitments to the supply constrained resource, the inquiries may be indicative of an expected future commitment, and thus maintaining a record of the inquiry can be useful for gauging resource availability at a future time.

User query modeling instructions 144 may involve one or more processes for addressing user queries. In the context of the present disclosure, the term "user query" refers to inquiries into feasibility of potential user requests. A user query may be addressed by indicating whether or not a specified amount of the supply constrained resource is available for the user to use at a specified time or within a specified window of time. Such an indication may inform the user whether or not to issue a request for the supply constrained resource in accordance with the specified parameters of the user's feasibility query. More generally, user queries may be addressed with any information that may inform the user's issuing of a request for the supply constrained resource, such as by indicating a different capacity of the supply constrained resource that may be available, a different time that the supply constrained resource may be available, a different set of conditions under which the supply constrained resource may be available such as disruption of one or more other workloads of the querying user, and so on.

Capacity data calculation instructions 146 may involve one or more processes for determining an appropriate partitioning of units of the supply constrained resource. In general, such determinations may be based on at least some of the resource availability information 132 and on the stored rules 134. For instance, the resource availability information 132 may include historical data indicating supply and demand of the supply constrained resource over time, and the stored rules 134 may be used to interpret the historical data to project supply and demand for the supply constrained resource.

It should be recognized that a projected supply of the supply constrained resource is not necessarily 100% of the potentially available capacity, since at any given time some of the resources may be unavailable to any users due to machine failures, outages, mandatory updates, or other causes for restricting availability. For example, if the total pool of an available supply constrained resource includes 100 machines, but the historical data indicates that at a given time only 80 of the 100 machines is available, then capacity data calculation instructions 146 may determine a partitioning of 80 machines of the supply constrained resource instead of a partitioning of all 100 machines.

Determining an appropriate partitioning of units may involve outputting a total number of partitions and a size of each partition. For example, for a partitioning of TPUs, the capacity data calculation instructions 146 may output slice budgets indicating a total number of available host slices as well as a size of each host slice. Continuing with the example of 80 out of 100 TPUs being available at a given time, such a partitioning may be 4 host slices of 20 TPUs each, 7 host slices of 10 TPUs each, or any other suitable combination that fits within the determined available capacity. It should be noted from the above examples that while the capacity data calculation instructions 146 may sometimes be maximized based on the historical data, such as determining to use all 80 TPUs that are projected to be available across 4 host slices, this is not a requirement of the capacity data calculation instructions 146, such as determining to use only 70 TPUs to be available across 7 host slices instead of using all 80 TPUs that are projected to be available across 8 host slices.

The input/output system 150 may be used to communicate data and instructions between the system 100 and external components such as the supply constrained resource 101 and one or more user devices belonging to the users 102. For example, a scheduler included in the system 100 may be capable of managing user requests for use of the supply constrained resource 101, which may involve receiving the user requests from users 102 through the input/output system 150 and communication instructions for operation of the supply constrained resource 101 through the input/output system 150 in accordance with a determined management of the user requests. For further example, the system may be capable of receiving user queries regarding feasibility of potential requests though the input/output system 150 and replying answers or responses to the user queries though the input/output system 150.

The network through which the system 100 may connect to external components may include various configurations and protocols including short range communication protocols such as Bluetooth^{™}, Bluetooth^{™} LE, the Internet, World Wide Web, intranets, virtual private networks, wide area networks, local networks, private networks using communication protocols proprietary to one or more companies, Ethernet, WiFi, HTTP, etc. and various combinations of the foregoing. Such communication may be facilitated by any device capable of transmitting data to and from other computing devices, such as modems and wireless interfaces. Computing device interfaces with the network through a communication interface, which may include the hardware, drivers and software necessary to support a given communications protocol.

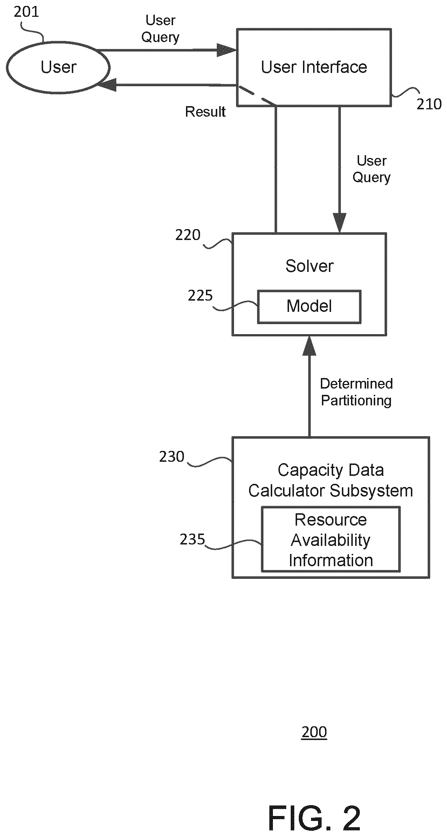

In operation, the system 100 of Fig. 1 is capable of receiving and processing user queries regarding feasibility of a hypothetical request for capacity of a supply constrained resource. Figs. 2-5 are block diagrams of example data flows for processing such user queries. Each of the systems shown in Figs. 2-5 may be comparable to the system 100 of Fig. 1 insofar as that it may perform the same or similar underlying operation. In this regard, systems shown in Figs. 2-5 may store the example data 122 of Fig. 1 and may execute the example instructions 124 of Fig. 1.

In the example system 200 of Fig. 2, a user interface 210 is provided for receiving and initially processing user queries. The user interface may be implemented using one or more processors of the system 200. The user query may be received at the user interface 210 from a user 201. In some examples, the user interface includes a program for issuing the user queries based on user input information. The user query may request information about feasibility of a hypothetical user request for use of a supply constrained resource. The user query may include one or more parameters or properties of the hypothetical user request. Example parameters may include: an amount of the supply constrained resource that is requested to be used for a given task; a time at which, or a time period over which, the supply constrained resource is requested to be used for the given task; a priority level of the given task which may indicate an importance of using the supply constrained resource for the given task as opposed to other, lower priority, tasks of the user; an urgency level of the given task which may indicate whether the given task must be performed at the specified time or may be postponed to a later time; and so on. Parameters may include any information that may be used by the system to return an indication of feasibility of the user query.

The user interface 210 may be programmed to, in response to receiving the user query, provide the user query to a solver 220. The solver 220 may be programmed to, in response to receiving the user query from the user interface, determine the feasibility of the user query based in part on the parameters included in the user query.

Feasibility of a user query may refer to a "yes" or "no" answer to whether the supply constrained resource specified in the user query are available within the time period specified in the user query. Additionally or alternatively, for user queries that return an answer of "no," feasibility may also refer to additional information that may inform a user whether to issue the same or a similar user request for the supply constrained resource. One example of such additional information may be an indication of a parameter change to the user query that would change the answer to the user query from "no" to "yes." For instance, if a smaller quantity of the supply constrained resource is available, the answer may indicate the quantity of the supply constrained resource for which the user query would return an answer of "yes." For further instance, if the specified quantity of the supply constrained resource is available at a different time, the answer may indicate the time at which the user query for the specified quantity of the supply constrained resource would return an answer of "yes."

Another example of additional information may be an indication of one or more other tasks that, if preempted by the task specified in the hypothetical user request, would change the response to the user query from "no" to "yes." For instance, a plurality of tasks of the user may be using the supply constrained resource at the time specified in the user query, and some of the plurality of tasks may have a lower priority level or lower urgency level than the task specified in the user query. In such a case, the additional information may indicate a group of one or more of those plurality of tasks that if stopped or postponed would free up availability of the supply constrained resource, thus making it possible for the task specified in the user query to be performed at that time.

It should be recognized that the additional information may similarly indicate a change in multiple parameters, such as indicating a different time from the specified time at which a different quantity of the supply constrained resource is available, indicating a different quantity of the supply constrained resource that could be available if a group of other tasks are preempted, indicating a different time at which the supply constrained resource that could be available if the group of other tasks are preempted, or any other possible combination of changed parameters.

In order to determine feasibility of the user queries, the solver 220 may operate a model 225 simulating a management of supply and demand of the supply constrained resource. In operation, the solver 220 may use the modeled supply and demand information to determine one or more possible allocations of the supply constrained resource. The determined allocations of resource may in turn be used to answer the user query.

Representing supply and demand in the model 225 involves modeling each of supply and demand of the supply constrained resource based on available information. In the example of Fig. 2, supply may be represented as an architecture of the collection of available supply constrained resource. An input for modeling the supply in the model 225 may be a determined partitioning of the supply constrained resource. Also in the example of Fig. 2, demand may be represented as user requests for using the supply constrained resource. An input for modeling the demand in the model 225 may be stored information about actual and/or potential user requests.

Behavior of the modeled supply and demand information within the model 225 may operate according to one or more predefined rules. The predefined rules may include one or more heuristics that define behavior of the available supply constrained resource and fulfillment of the user requests, such as a set time for fulfillment of a given task. Additionally or alternatively, the model 225 may be implemented as a machine learning model, whereby behavior of the available supply constrained resource and fulfillment of the user requests may be modeled according to historical performance data that indicates user requests provided to the supply constrained resource and performance of the resources in handling those requests. In such an implementation, the historical performance data may be used to train the model 225 in order for future model behavior to more closely resemble the historical performance data. For instance, and by way of example, historical performance data may be used to classify certain tasks assigned to the supply constrained resource and project either or both of a capacity or an amount of time needed in order to fulfill the task. For further example, historical performance data may be used to predict performance of the supply constrained resource at a given partition size and then base the projected capacity and/or amount of time needed for fulfilling a task based on the predicted performance. Using a machine learning model to model behavior of the available supply constrained resource and fulfillment of the user requests also allows for the modeled behavior to be dynamically adjusted as additional user requests are submitted and further performance data is collected.

With respect to using the model 225 to determine allocations of the supply constrained resource, such determinations may involve identifying or predicting computational requirements, memory needs and data dependencies of existing user requests for the supply constrained resource. These predictions could be made using information contained within existing user requests, from historical information about similar requests, or a combination thereof. The determinations may be based on additional factors, including but not limited to predetermined rules for allocation, and assigned priorities of tasks associated with the requests.

Once the solver 220 determines the possible allocations of the supply constrained resource according to the parameters of the user query, it may be determined whether a user request having those parameters is feasible. Similarly, the solver may be capable of determining allocations of the supply constrained resource according to adjusted sets of parameters, or adjusted conditions of other tasks assigned to the supply constrained resource, such as preempting one or more tasks, and then determine whether a user request having those adjusted parameters is feasible. The solver 220 may be further programmed to collect the scenarios or combinations of parameters for which the user request would be feasible and provide this information as an output.

In some implementations, the solver may be programmed to provide only "yes" or "no" answers to feasibility. Such answers are commonly the most helpful for prospective customers of the supply constrained resource, since they provide the most definitive information as to whether a potential user request should or should not be made. However, in some implementations, the solver 220 may be programmed to interpret the model 225 to provide a degree of likelihood of feasibility instead of an absolute "yes" or "no." For example, in the case of a machine learning model, the model may return not just a "yes" or "no" result but also a likelihood of the result. The likelihood may be output as a percentage likelihood of feasibility. Percentage likelihoods may be informative for some potential users of the supply constrained resource, such as by representing by how much a likelihood of feasibility increases for a user request by changing one or more parameters, by preempting one or more other tasks, or both.

The result of the user query is output from the solver 220 and provided back to the user. In the example of Fig. 2, the solver output is shown as being provided to the user interface 210, which in turn may provide the solver output to the user 201. In practice, the user 201 may issue further user queries or user requests based on the received solver output. For example, if the result shown in the solver output indicates feasibility of the user query, then the user may wish to follow up with a user request to use the supply constrained resource as previously indicated in the user query. For further example, if the result shown in the solver output indicates feasibility of the user query with modified parameters and/or preemption of one or more other tasks, then the user may wish to follow up with one or more instructions, such as a user request to use the supply constrained resource according to the modified parameters, a user instruction to preempt one or more other tasks, or both. For further example, if the result shown in the solver output indicates non-feasibility of the user query, then the user may wish to follow up with a different user query, such as a query to perform a different or modified task.

In some implementations, the solver 220 may also function as a scheduling engine for scheduling actual user requests for the supply constrained resource. In operation, the scheduling engine may be configured to determine a logical allocation of the supply constrained resource for executing tasks of the user requests received at the system 200. In such an implementation, the scheduling engine may rely on either or both of predefined rules and a model to project behavior of the tasks to be scheduled and the supply constrained resource used for fulfilling the tasks. In other words, the scheduling engine may utilize the solver in order to determine an appropriate scheduling of requested tasks.

In the example of Fig. 2, information about user requests used for modeling demand may be stored at a storage location within the system 200 or accessed from a storage location external from the system 200. The solver 220 may be programmed to communicate with the storage location in order to receive up to date information. The stored user request information may include both current user requests and historical data such as past user requests, as well as performance data concerning performance of the current and past user requests. For instance, modeling a current state of the supply constrained resource may be based on the current user requests, while modeling expected performance of the system, including both the user request indicated within the user query and any other concurrent user requests, may be based on performance data of the current and past user requests.

In the example of Fig. 2, the determined partitioning of the supply constrained resource used for modeling supply in the model 225 is received from a capacity data calculator subsystem 230. The capacity data calculator subsystem 230 may operate one or more processors of the system 200 to determine the partitioning based on resource availability information 235. The resource availability information 235 may be stored within the system 200 or accessed from a storage location external from the system 200. Resource availability information 235 generally includes data about a currently available capacity of the supply constrained resource. In some cases, the resource availability information 235 may further include data about future available capacity of the supply constrained resource. Future available capacity may vary based on expected changes to availability, such as a scheduled update or a forecast indicating a possible outage.

The resource availability information 235 may further include information about each or both of a physical or network topology of the supply constrained resource. Physical topology of the resource may refer to a physical arrangement of units of the supply constrained resource. Physical topology may impact a determined partitioning insofar as physical proximity and connectivity between units can affect performance. Network topology of the resource may refer to an interconnection between units of the supply constrained resource, as well as connections between the units and other components and infrastructure utilized by the components, such as storage systems, secondary computational resources, and the like. Network topology may impact a determined partitioning insofar as network latency, bandwidth, and data transfer rates between units and with other components can also affect performance.

In the example of a TPU as a supply constrained resource, TPUs are often organized in clusters, pods or other hierarchical structures. These structures may affect the physical and network topology of the TPUs and may impact performance of various slice budgets. Thus, resource availability information 235 containing physical and network topology data may be beneficial for efficient calculation of TPU slice budgets. Similar benefits can be yielded for other supply constrained resources for which availability of the resources may vary according to physical topology, network topology, or both.

Since the determined partitioning of the supply constrained resource is based on both current and future availability data, the capacity data calculator subsystem 230 may determine a partitioning that is optimal or otherwise suitable with both the current and future expected availability of the resource. Alternatively, the capacity data calculator subsystem 230 may be programmed to determine a time series of partitionings in which the partitionings may adjust over time based on changes indicated in the current and future availability data. In such an arrangement, the solver 220 may be capable of processing the user query based on the received time series of partitionings.

In the example of Fig. 2, the solver 220 may be programmed to retrieve up to date information about user requests whenever it initiates modeling of supply and demand. For instance, if the solver 220 also operates as a scheduler, then the solver may obtain the up to date information about user requests any time a new user request is received in order to avoid scheduling conflicts. In other words, any time a new request is scheduled, it is necessary to update the user request information to reflect the scheduled request so that conflicting requests are not scheduled in the future. By contrast, with regard to resource availability information 235, available capacity is not expected to change from one scheduling operation to the next. Therefore, this information may be pushed to the solver 220 at predefined intervals. For instance, in the case of computing slice budgets for TPUs, the slice budget information may be relied on by the solver 220 to project feasibility and/or schedule tasks until updated slice budgets are provided.

The example of Fig. 2 illustrates an example data flow suitable for pushing resource availability information 235 to the solver 220 at predefined intervals. The predefined intervals may be set to facilitate regular updating of slice budgets. This may be beneficial for ensuring that any changes to available capacity are adequately monitored by the capacity data calculator subsystem 230 and accounted for by the solver 220.

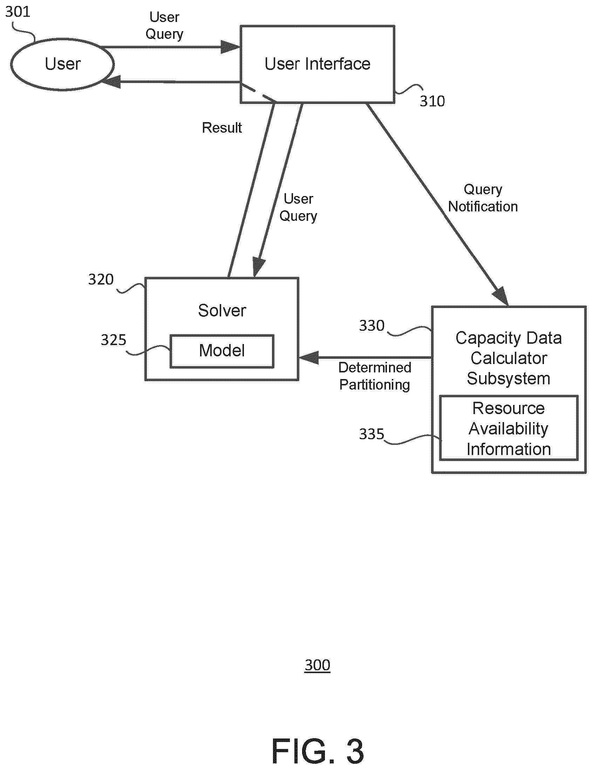

In other implementations, instead of pushing resource availability information 235 to the solver 220 at predefined intervals, the resource availability information 235 may be provided to the solver 220 on an on-demand basis. Fig. 3 is an example data flow for facilitating on-demand access to resource availability information 235.

In the example of Fig. 3, the system 300 includes a user interface 310 for receiving user queries from a user 301, a solver 320 using a model 325 to answer the received user queries, and a capacity data calculator subsystem 330 for determining partitioning of a supply constrained resource based on resource availability information 335.

These features and operations of the system 300 of Fig. 3 may be comparable to the corresponding features and operations of the system 200 of Fig. 2, except that in the example system 300 of Fig. 3, the user interface 310 is further programmed to transmit a query notification to the capacity data calculator subsystem 330, and the capacity data calculator subsystem 330 is further programmed to initiate accessing the resource availability information 335 and pushing the resource availability information 335 to the solver 320. In effect, the notification indicates receipt of a new user query at the user interface 310, and effectively serves as a request to the capacity data calculator subsystem 330 to update the information previously provided to the solver 320. In this manner, communicating the query notification from the user interface 310 to the capacity data calculator subsystem 330 ensures that the user query is processed by the solver 320 using the most up to date information about the available supply of the supply constrained resource.

It should be recognized that the on-demand updating of resource availability information 335 at the solver 320 does not prevent the system from also regularly updating the resource availability information 335. In other words, in some implementations, the capacity data calculator subsystem 330 may be programmed to push resource availability information 335 at predefined intervals, in response to a query notification, or both.

In the example data flows of Figs. 2 and 3, the user query indicates a possible interest of the user 201, 301 to use the requested supply constrained resource, possibly depending on the result of the feasibility determination by the solver 220, 320 in response to the user query. Such user interest may reflect an increased probability of the user committing to using the resources specified in the user query at a future time, such as the time or time range specified in the user query. However, the user query is not itself a commitment by the user to use the particular resources specified within the query. Therefore, while it may be beneficial for the solver 220, 320 to factor in user queries when modeling demand of the supply constrained resource for the purpose of predicting feasibility of a user query, it would also be detrimental for the solver 220, 320 to interpret the user query as an absolute commitment to using the resources. For instance, a solver that also functions as a scheduler should not treat user queries as commitments to the specified resources since this would result in conflicts that would prevent other users from committing to those same resources. Therefore, it is advantageous for the solver 220, 320 to be capable of factoring the resources specified in prior user queries when addressing a current user query, but also capable of avoiding factoring the resources specified in prior user queries when scheduling a current user request.

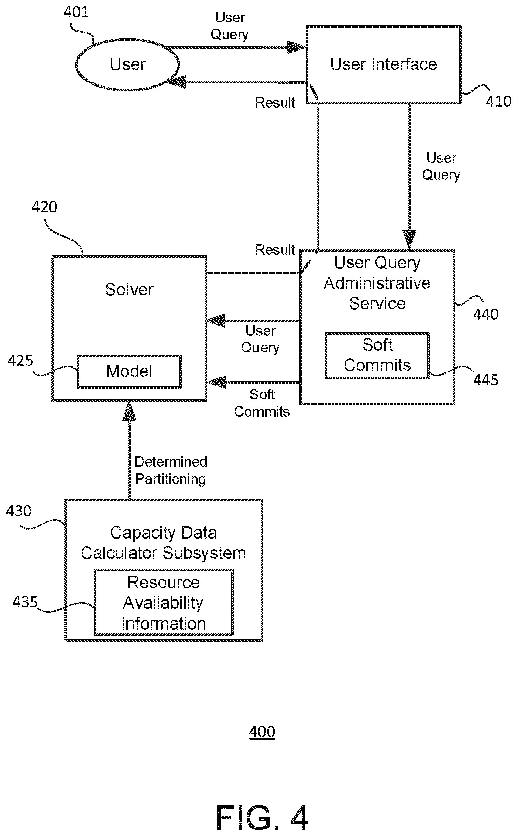

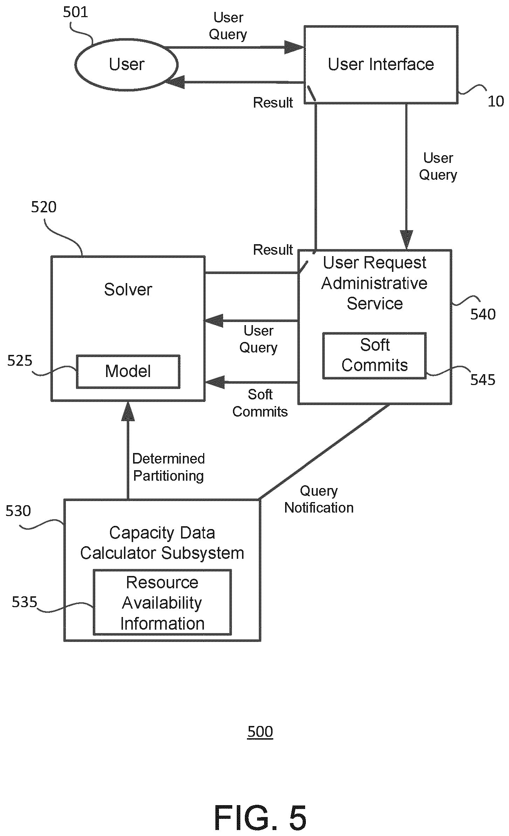

One way of configuring the solver to treat the resources specified in user queries appropriately is to treat the user query as a soft commit. The soft commits may be stored separately from user requests in order to avoid conflation between the two. Figs. 4 and 5 illustrate example data flows for facilitating the separate storage of soft commits and user requests.

In the example of Fig. 4, the system 400 includes a user interface 410 for receiving user queries from a user 401, a solver 420 using a model 425 to answer the received user queries, and a capacity data calculator subsystem 430 for determining partitioning of a supply constrained resource based on resource availability information 435. These features of the system 400 of Fig. 4 may be comparable to the corresponding features and operations of the system 200 of Fig. 2. Additionally, the system 400 includes a user query administrative service 440 programmed to manage incoming user queries. The user query administrative service 440 may be operated by one or more processors included in the system 400, and may serve as a single source of truth for soft commits 445 in the system 400.

In operation, the user query administrative service 440 may receive the user query from the user interface 410, and may provide the user query to the solver 420. These operations are comparable to the corresponding operations described in connection with Fig. 2. Additionally, the user query administrative service 440 may store the user request as a soft commit 445. The user query administrative service 440 may also provide the stored soft commits 445 to the solver 420 along with the user query. The solver 420 may be capable of modeling demand of the available supply constrained resource based on the soft commits in combination with the user query and the historical data of current and prior user requests.

In the example of Fig. 4, the user query administrative service 440 may also be capable of handling incoming user requests for using the supply constrained resource. For example, if the solver 420 responds to a user query by indicating that the user query is feasible in its original form or with modifications, or then a user may wish to issue a user request to commit to the resources specified in the user query or as modified in the solver's response. Such a user request would convert the soft commit into an actual commitment. Thus, in response to receiving such a user request from the user 401, the user query administrative service 440 may be programmed to not only instruct the solver 420 or a separate scheduler to schedule and store the user request, but also to remove the previously stored soft commit corresponding to the user request from its storage.

In the example of Fig. 5, the system 500 includes a user interface 510 for receiving user queries from a user 501, a solver 520 using a model 525 to answer the received user queries, a capacity data calculator subsystem 530 for determining partitioning of a supply constrained resource based on resource availability information 535, and a user query administrative service 540 for storing and managing soft commits. These features and operations of the system 500 of Fig. 5 may be comparable to the corresponding features and operations of the system 400 of Fig. 4, except that in the example system 500 of Fig. 5, the user interface 510 is further programmed to transmit a query notification to the capacity data calculator subsystem 530, and the capacity data calculator subsystem 530 is further programmed to initiate accessing the resource availability information 535 and pushing the resource availability information 535 to the solver 520. In this manner, operation of the system 500 of Fig. 5 is comparable to that of the system 300 of Fig. 3, except that the system 500 of Fig. 5 is further capable of managing soft commits 545 and factoring the soft commits 545 in the model 525 along with the up-to-date resource availability information 535. Thus, the modeled supply and demand used by the solver 520 in Fig. 5 can potentially reflect performance of the supply constrained resource more accurately than the models in the other example systems 200, 300, 400.

### Example Methods

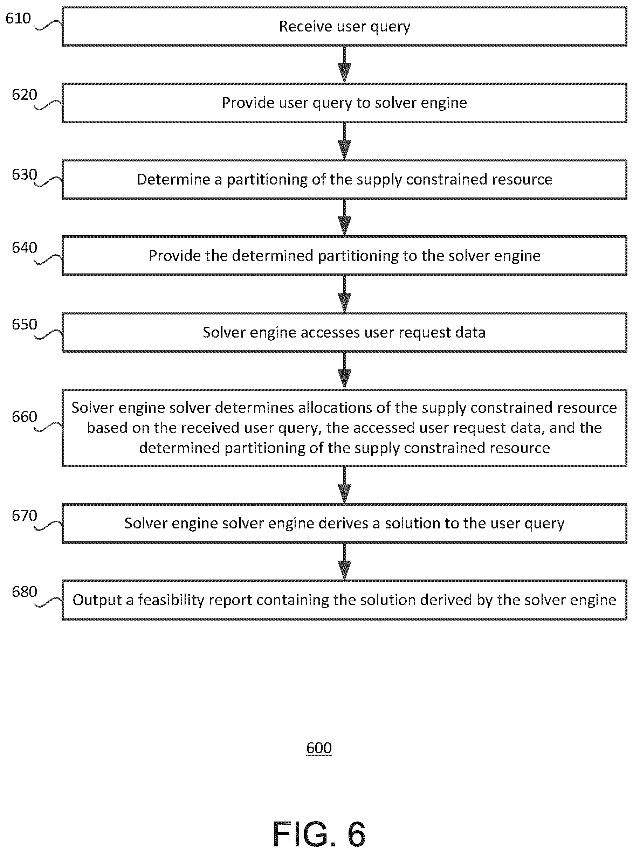

Fig. 6 is a flow diagram illustrating an example routine 600 that may be performed by a system of the present disclosure, such as the example systems described in connection with Figs. 1-5.

At block 610, one or more processors of the system receive a user query. The user query may specify a supply constrained resource, and may further include one or more parameters. The parameters may specify an amount of the supply constrained resource to be used, and time or time range at which the supply constrained resource is to be used, or other conditions for use of the supply constrained resource, such as a priority level of the use or a time sensitivity of the use.

At block 620, the one or more processors of the system provide the user query to a solver engine. The solver engine may operate a model simulating management of the supply constrained resource as each of available capacity and requested capacity fluctuate. The solver may utilize the model to derive one or more solutions to the user query.

At block 630, the one or more processors of the system may determine a partitioning of the supply constrained resource. The partitioning may be a dynamically adjustable topology of the supply constrained resource, such as slice budgets in the case of an available capacity of TPUs, and may be based on resource availability information. The resource availability information may be data about a currently available capacity of the supply constrained resource, future available capacity of the supply constrained resource, or both.

At block 640, the one or more processors of the system provide the determined partitioning of the supply constrained resource to the solver engine. The determined partitioning of the supply constrained resource may represent an available supply of the supply constrained resource over a duration of time, including a current time and future times. For instance, in the case of slice budgets of TPU capacity, the determined partitioning may be represented as a time series of slice budgets.

At block 650, the solver engine may further access user request data. The user request data may be stored information from previously received user requests to use the supply constrained resource, may indicate current allocations of the supply constrained resource to fulfill current user requests, future allocations of the supply constrained resource to fulfill future user requests, or both.

At block 660, the solver engine may determine one or more allocations of the supply constrained resource based on the received user query, the accessed user request data, and the determined partitioning of the supply constrained resource. The allocations may be determined according to a model for simulating management of supply and demand of the supply constrained resource, whereby the partitioning of the supply constrained resource is indicative of supply and the user request data is indicative of demand.

At block 670, the solver engine may derive a solution to the user query based on the one or more determined allocations of the supply constrained resource. In some examples, the solution may be only a "yes" or "no" response as to feasibility of a user request containing the parameters indicated in the user query. In other examples, the solution may provide further insight into what parameters would result in a response of "yes" as to feasibility, such as a modification of one or more parameters or a preemption of another task that is already assigned to the supply constrained resource.

At block 680, the one or more processors of the system may output a feasibility report containing the solution derived by the solver engine. Outputting the feasibility report may involve providing the feasibility report to a source from which the user query originated, such as a user device of the user. The solution included in the feasibility report may provide insight to the user as to feasibility of the user query.

In some example routines, block 620 may further involve providing previously stored user queries to the solver engine. The previously stored user queries may be queries initiated by the same user as the current user query, or by different users. Additionally, the previously stored user queries are different from the user request data provided at block 650. User request information provided at block 650 indicates a commitment by a user to use the supply constrained resource, whereas user query information provided at block 620 indicates a capacity of the supply constrained resource that a user may possibly request to use in a yet-to-be-received user request. The yet-to-be-received user request is effectively inferred from the fact that the stored user query inquires about a feasibility of the yet-to-be-received user request, meaning that there is an increased likelihood of such a user request to be issued.

It should be recognized that the steps shown in blocks 610-680 of the routine 600 need not be performed strictly in the order specified above. For example, in some implementations, the operations of blocks 630 and 640 may be performed at any time, such as before the user query is received, or between when the user query is received and when the user query is provided to the solver engine. In such implementations, the operations of blocks 630 and 640 may be programmed to be performed at regularly scheduled intervals, which may be either fixed or variable according to one or more factors such as an amount of user requests received to the system over a given span of time. Alternatively, in order implementations, the operations of blocks 630 and 640 may be initiated in response to another operation of the routine 600. For example, in one implementation, receiving the user query at block 610 may act as a trigger to initiate the determination of a partitioning of the supply constrained resource at block 630, and the determination of the partitioning at block 630 may trigger the determined partitioning to be provided to the solver engine at block 640. Such an implementation may effectively generate partitionings of the supply constrained resource on an on-demand basis in response to user queries.

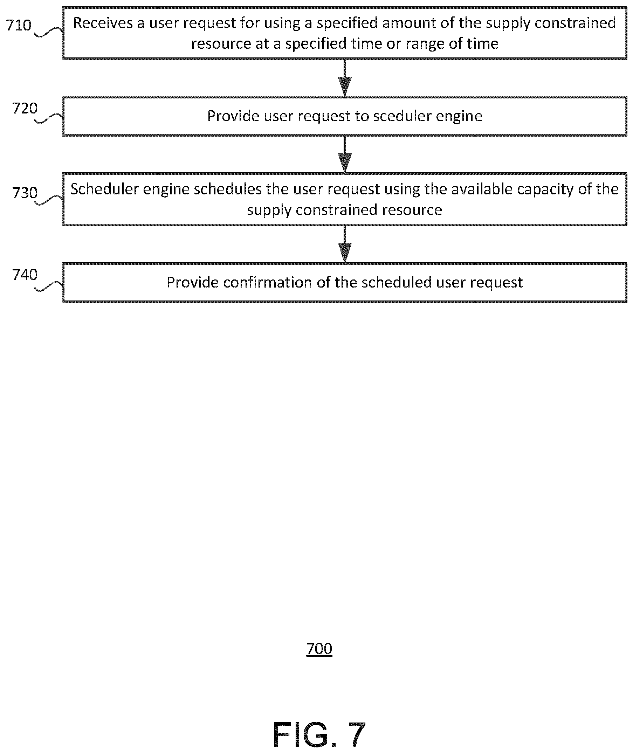

For a scenario in which the system provides a "yes" response to the user query, the user may wish to execute a user request to commit to using the supply constrained resource. Fig. 7 is a flow diagram of a further routine 700 illustrating additional operations that may be performed in continuation of the routine 600 of Fig. 6 to manage the user request.

At block 710, the one or more processors receives the user request for using a specified amount of the supply constrained resource at a specified time or range of time. The user request may include additional information or parameters, such as a priority level of the user request, a time-sensitivity of the user request, and possibly a listing of one or more other tasks that should be preempted by scheduling of the user request.

At block 720, the one or more processors provide the user request to a scheduler engine. At block 730, the scheduler engine schedules the user request using the available capacity of the supply constrained resource. The scheduler engine may determine an appropriate allocation of the supply constrained resource to perform tasks included in the user request. In one implementation, the scheduler engine may utilize the same program as the solver engine in order to determine the allocation. In another implementation, the scheduler engine may be separate from the solver engine. In either implementation, the scheduler engine may be capable of accessing the same information to manage the user requests as the information used to manage the user queries. For instance, the scheduler engine may access historical data concerning past, current and future user requests, and may access resource availability information. This collection of information may be used to determine the appropriate allocation of the supply constrained resource in the same or similar manner as described herein in connection with the solver engine.

Optionally, at block 740, the one or more processors may provide a confirmation of the scheduled user request to the user in response to allocation of the supply constrained resource at block 730. The confirmation may be transmitted to an origin of the user request, and may indicate to the user that the user request has been successfully scheduled by the system.

In some examples, the operations of block 740 may further include internal operations at the system to avoid future conflicts. For example, upon scheduling the user request, the one or more processors may update the historical data to reflect the newly scheduled tasks. Additionally, for those systems in which user queries are stored and used as soft commits for evaluating feasibility of later-submitted queries, the one or more processors of the system may be programmed to identify a user query associated with the scheduled user request and remove it from storage among the soft commits. This may be done since the user query is now a fully committed user request that is no longer likely to be scheduled but rather has already been scheduled.

As shown above, the present disclosure provides methods and systems for managing user queries concerning fulfillment of requests to use a supply constrained resource. A method may involve receiving a user query specifying a requested supply constrained resource, the user query including one or more parameters, providing the user query to a solver engine, accessing availability information indicating an availability of the supply constrained resource, determining a partitioning of the supply constrained resource based on the availability information, providing the determined partitioning of the supply constrained resource to the solver engine, determining, by the solver engine, a feasibility of a user request to use the supply constrained resource having the one or more parameters of the user query, and outputting, from the solver engine, the determined feasibility of the user request.

The example systems and methods described herein are capable of providing reliable and up-to-date reflections of feasibility for user queries of a supply constrained resource. This has the benefit of greatly simplifying capacity user management decisions, increasing user confidence and willingness to commit to resources, optimizing resource utilization, and increasing user satisfaction with resource availability. The example systems and methods are further capable of providing more nuanced feedback to users than a simple "yes" or "no" answer regarding feasibility, as the Furthermore, for query determinations achieved using a model that simulates supply and demand of the supply constrained resource, the model may provide a generalized solution that can work for almost any user query, which in turn makes the methods and systems described herein both repeatable and easily scalable.

Additionally, the example systems and methods are described herein as being most relevant and applicable for supply constrained resources. However, it should be recognized that the same or similar underlying principles can be applied to other multi-host interconnected architecture, such as an interconnected architecture of computing devices. In such an arrangement, modeling availability of a resource may take into account the relative speed at which supply and demand change. For instance, demand may increase at a given time faster than new components can be purchased for the demanded resource, thus making the resource at least temporarily supply constrained. The model may then be useful for projecting availability of the resource over time and providing feedback to user queries concerning feasibility of a hypothetical request to use the resource.

Although the technology herein has been described with reference to particular embodiments, it is to be understood that these embodiments are merely illustrative of the principles and applications of the present technology. It is, therefore, to be understood that numerous modifications may be made to the illustrative embodiments, and that other arrangements may be devised without departing from the spirit and scope of the present technology as defined by the appended claims.

Most of the foregoing alternative examples are not mutually exclusive, but may be implemented in various combinations to achieve unique advantages. As these and other variations and combinations of the features discussed above can be utilized without departing from the subject matter defined by the claims, the foregoing description of the embodiments should be taken by way of illustration rather than by way of limitation of the subject matter defined by the claims. As an example, the preceding operations do not have to be performed in the precise order described above. Rather, various steps can be handled in a different order, such as reversed, or simultaneously. Steps can also be omitted unless otherwise stated. In addition, the provision of the examples described herein, as well as clauses phrased as "such as," "including", and the like, should not be interpreted as limiting the subject matter of the claims to the specific examples; rather, the examples are intended to illustrate only one of many possible embodiments. Further, the same reference numbers in different drawings can identify the same or similar elements.

## Claims

1. A method, comprising:
receiving a user query specifying a requested supply constrained resource, wherein the user query includes one or more parameters;
providing the user query to a solver engine;
providing to a capacity data calculator service, availability information indicating an availability of the supply constrained resource;
determining, by the capacity data calculator service, a partitioning of the supply constrained resource based on the availability information;
providing the determined partitioning of the supply constrained resource to the solver engine;
determining, by the solver engine, a feasibility of a user request to use the supply constrained resource having the one or more parameters of the user query, wherein determining the feasibility is based on a model of supply and demand of the supply constrained resource, wherein supply of the supply constrained resource is modeled according to the determined partitioning of the supply constrained resource; and
outputting, from the solver engine, the determined feasibility of the user request.

2. The method of claim 1, wherein the one or more parameters includes at least:
an amount of the supply constrained resource to be used for a given task; and
a time at which, or a time period over which, the supply constrained resource is to be used for the given task.

3. The method of claim 1 or 2, wherein the one or more parameters further includes a priority level of the given task indicating to prioritize use of the supply constrained resource for the given task over other tasks having a lower priority level.

4. The method of any one of the preceding claims, wherein feasibility of the user request indicates whether or not the user request having the one or more parameters can be fulfilled using an available capacity of the supply constrained resource.

5. The method of claim 4, wherein:
feasibility of the user request further indicates, for a user request that cannot be fulfilled using the available capacity of the supply constrained resource, a modified set of parameters for which the user request having the modified set of parameters can be fulfilled using the available capacity of the supply constrained resource; or
feasibility of the user request further indicates, for a user request that cannot be fulfilled using the available capacity of the supply constrained resource, one or more existing tasks for which preemption of the one or more tasks would result in the user request being capable of being fulfilled using the available capacity of the supply constrained resource.

6. The method of any one of the preceding claims, wherein:
feasibility of the user request indicates a percentage likelihood of whether or not the user request having the one or more parameters can be fulfilled using an available capacity of the supply constrained resource;
the availability information indicates one or more topologies of the supply constrained resource, and wherein the determined partitioning is based on the one or more topologies;
providing the determined partitioning of the supply constrained resource to the solver engine is performed at predetermined intervals; or
the method further comprises, in response to receiving the user query, pushing a query notification to the capacity data calculator service, wherein the query notification includes an instruction for the capacity data calculator service to update the partitioning of the supply constrained resource and provide the updated partitioning to the solver.

7. The method of any one of the preceding claims, wherein in the model of supply and demand of the supply constrained resource, demand of the supply constrained resource is modeled according to historical data of current and prior user requests for use of the supply constrained resource.

8. The method of claim 7, wherein:
the historical data includes performance data indicating performance of resources handling the current and prior user requests; or
the model is a machine learning model that is trained on the performance data and the determined partitioning of the supply constrained resource.

9. The method of any one of the preceding claims, wherein:
the determined partitioning of the supply constrained resource is a time-series of slice budgets of the supply constrained resource over a span of time; or
the determined partitioning of the supply constrained resource is a time-series of slice budgets of the supply constrained resource over a span of time, and the supply constrained resource is one of a graphics processing unit (GPU) or a tensor processing unit (TPU).

10. The method of any one of the preceding claims, further comprising:
storing the user query including the one or more parameters in a user query storage containing a plurality of previously received user queries;
providing the plurality of previously received user queries to the solver engine, wherein in the model of supply and demand of the supply constrained resource, demand of the supply constrained resource is modeled at least in part according to the plurality of previously received user queries.

11. The method of claim 10, further comprising:
receiving a user request committing to use of the supplied constrained resource, the user request corresponding to the user query;
providing the user request to a scheduler engine to allocate the supply constrained resource for fulfillment of the user request; and
in response to receipt of the user request, deleting the corresponding user query from the user query storage.

12. The method of any one of the preceding claims, further comprising:
receiving a user request committing to use of the supplied constrained resource, the user request corresponding to the user query;
providing the user request to a scheduler engine; and
allocating, by the scheduler engine, the supply constrained resource for fulfillment of the user request.

13. The method of claim 12, allocating the supply constrained resource is based on the model of supply and demand of the supply constrained resource.

14. A system comprising:
one or more processors; and
memory having stored therein instructions configured to cause the one or more processors to:
receive a user query specifying a requested supply constrained resource, wherein the user query includes one or more parameters;
provide the user query to a solver engine;
access availability information indicating an availability of the supply constrained resource;
determine a partitioning of the supply constrained resource based on the availability information;
provide the determined partitioning of the supply constrained resource to the solver engine;
receive, from the solver engine, an indication of feasibility of a user request to use the supply constrained resource having the one or more parameters of the user query, wherein the indication of feasibility is based on a model of supply and demand of the supply constrained resource, wherein supply of the supply constrained resource is modeled according to the determined partitioning of the supply constrained resource; and
output the determined feasibility of the user request to a source of the user query.

15. A computer program comprising instructions which, when the program is executed by one or more processors, cause the one or more processors to carry out steps of the method according to any one of claims 1 to 13.
